# EUROPÄISCHE PATENTANMELDUNG

(11) **EP 1 734 802 A2**
(43) Veröffentlichungstag der Anmeldung: **20.12.2006**
(21) Anmeldenummer: 06115056.1
(22) Anmeldetag: 07.06.2006
(51) Int. Cl.: H05K 13/04

(54) **Bestückkopf für einen Bestückautomaten zum Bestücken von Substraten mit elektrischen Bauteilen**

(30) Priorität: 16.06.2005 DE 102005027901
(71) Anmelder: SIEMENS AKTIENGESELLSCHAFT, 80333 München (DE)
(72) Erfinder: Burger, Stefan, 81379, München (DE)

(57) **Zusammenfassung**

Ein Bestückkopf (6) für einen Bestückautomat (1) zum Bestücken von Substraten mit elektrischen Bauteilen (5), umfasst eine Montagefläche (15), mehrere Linearführungen (16), mehrere Greifereinheiten (12), welche jeweils mit einer der Linearführungen (16) gekoppelt und entlang der jeweiligen Linearführung (16) relativ zur Montagefläche (15) verschiebbar sind, und mehrere Linearmotoren (18), welche jeweils einer der Greifereinheiten (12) zugeordnet und derart angeordnet sind, dass die Greifereinheiten (12) mittels der Linearmotoren (18) entlang der Linearführungen (16) verfahrbar sind, wobei Stationärteile (19) der Linearmotoren (18) mit der Montagefläche (15) und Mobilteile (20) der Linearmotoren (18) mit den Greifereinheiten (12) fest verbunden sind.

## Beschreibung

Die Erfindung betrifft einen Bestückkopf für einen Bestückautomaten zum Bestücken von Substraten mit elektrischen Bauteilen, insbesondere einen so genannten Matrix- oder Zeilenbestückkopf.

In der Bestücktechnik werden Substrate bzw. Leiterplatten in einem Bestückautomaten mit elektrischen Bauteilen bestückt. Die Substrate werden dabei über eine Transportstrecke zu einem Bestückplatz des Bestückautomaten transportiert, dort bestückt und anschließend vom Bestückplatz weg transportiert. Seitlich der Transportstrecke sind in einem Zuführbereich Zuführeinrichtungen vorgesehen, welche die elektrischen Bauteile bereitstellen. Der Bestückautomat verfügt über einen Bestückkopf, welcher mittels eines Positioniersystems parallel zur Bestückebene zwischen dem Zuführbereich und dem Bestückbereich verfahrbar ist. Der Bestückkopf nimmt dabei die von den Zuführeinrichtungen bereitgestellten Bauteile auf und verfährt in den Bestückbereich, um dort die Substrate mit den Bauteilen zu bestücken. Dabei kommen auch so genannte Matrix-oder Zeilenbestückköpfe zum Einsatz. Diese Typen von Bestückköpfen weisen meist mehrere Greifereinheiten auf, welche zeilen- oder matrixartig nebeneinander angeordnet sind und individuell senkrecht zur Bestückebene in Richtung der Substrate verschiebbar sind. Die Bewegung der einzelnen Greifereinheiten geschieht häufig mittels Linearmotoren.

Ein bekannter Matrixbestückkopf ist so ausgestattet, dass jede einzelne Greifereinheit über einen eigenen kompletten Linearmotor verfügt. Die Einzelmotoren sind jeweils so konstruiert, dass zwischen zwei sich gegenüber stehenden Statorplatten, welche jeweils aus einer Eisenrückschlussplatte und darauf montierten Permanentmagneten 20 bestehen, ein bestrombares, beweglich gelagertes Spulenteil angeordnet ist. Ein Greifer der Greifereinheit ist mit dem mobilen Spulenteil fest verbunden und dadurch senkrecht zur Bestückebene verfahrbar, um Bauteile aufzunehmen oder sie auf dem Substrat abzusetzen. Diese Art von Matrixbestückkopf erweist sich jedoch als teuer in der Herstellung und zeitaufwendig in der Montage, da alle Linearmotoren einzeln montiert werden müssen. Ferner erfordert der beschriebene Aufbau einen relativ großen Bauraum.

Es ist deshalb die Aufgabe der vorliegenden Erfindung, einen Bestückkopf mit einfacherem Aufbau zu liefern.

Diese Aufgabe wird durch den Bestückkopf gemäß dem unabhängigen Anspruch 1 gelöst.

Ein Bestückkopf gemäß dem unabhängigen Anspruch 1 umfasst eine Montagefläche, mehrere Linearführungen und mehrere Greifereinheiten. Jede der Greifereinheiten ist jeweils mit einer der Linearführungen gekoppelt und entlang dieser relativ zu der Montagefläche verschiebbar. Zum Antrieb der Greifereinheiten umfasst der Bestückkopf ferner mehrere Linearmotoren mit je einem Mobilteil und einem Stationärteil, wobei jeweils ein Linearmotor einer der Greifereinheiten zugeordnet ist. Die Mobilteile der Linearmotoren sind dabei mit der jeweiligen Greifereinheit fest verbunden, um diese entlang der Linearführungen zu bewegen. Der erfindungsgemäße Bestückkopf zeichnet sich insbesondere dadurch aus, dass eine gemeinsame Montagefläche zur Befestigung der Stationärteile mehrerer Linearmotoren, zumindest jedoch zweier Linearmotoren, vorgesehen ist. Dadurch ist es möglich, die Stationärteile mehrerer Linearmotoren zusammen mit der gemeinsamen Montagefläche als ein einzelnes vormontiertes Modul bzw. Montageeinheit auszuführen, wodurch die Montage einfacher, schneller und kostengünstiger durchgeführt werden kann.

Der Bestückkopf kann gemäß Anspruch 2 auch dahingehend ausgestaltet werden, dass die Stationärteile der Linearmotoren an der Montagefläche in einer gemeinsamen Ebene angeordnet sind. In diesem Fall können die Stationärteile der Linearmotoren gemeinsam auf einer Seitenfläche einer einfachen Montageplatte befestigt sein. Einander zugewandte Flächen des Stationärteils und des zugehörigen Mobilteils eines jeden Linearmotors sind dabei parallel zu der Montagefläche angeordnet. Dies erlaubt eine weitere Vereinfachung des Aufbaus des Bestückkopfes und damit eine weitere Reduktion von Kosten und Bauraum.

Eine noch weitergehende Vereinfachung des Aufbaues kann gemäß Anspruch 3 dadurch erreicht werden, dass die Montagefläche als eine erste gemeinsame ferromagnetische Rückschlussplatte für die Linearmotoren ausgebildet ist. Die ferromagnetische Rückschlussplatte weist dabei ein Material mit hoher magnetischer Flussleitfähigkeit auf, was den Wirkungsgrad der Linearmotoren erheblich erhöht. Die Montagefläche bzw. die Montageplatte übernimmt dadurch gleichzeitig die Funktion der Rückschlussplatte für die Linearmotoren, was eine weitere Zusammenfassung von Bestandteilen der Linearmotoren mit sich bringt.

Gemäß Anspruch 4 handelt es sich bei den Stationärteilen der Linearmotoren um bestrombare Spulenelemente und bei den Mobilteilen um Permanentmagnete. Bei diesem Aufbau ist vorteilhaft, dass die Permanentmagnete zu bewegen sind, wogegen die zu bestromenden Spulenelemente stationär fest an der Montagefläche montiert sind (moving magnet). Dadurch, dass die Spulen den stationären Teil des Linearmotors ausmachen, sind die Ansprüche und damit auch die Kosten für die zu den Spulenelementen führenden Stromleitungen sowie die nötigen Steckerverbindungen erheblich niedriger anzusetzen, als im umgekehrten Fall, in dem die Spulenelemente die bewegten Teile der Linearmotoren darstellen. Dadurch können die Kosten des Bestückkopfs reduziert und die Zuverlässigkeit gesteigert werden.

Gemäß Anspruch 5 kann der Bestückkopf dahingehend ausgestaltet werden, dass auf der Montagefläche eine Leiterplatte befestigt, beispielsweise aufgeklebt, ist, welche die zu den ebenfalls an der Montagefläche angeordneten Spulenelementen führende Stromleitungen aufweist, um die Spulenelemente mit einer externen Stromversorgung zu verbinden. Die Stromleitungen können dabei zu einem gemeinsamen Stromanschluss-Stecker der Leiterplatte führen, so dass nur eine einzige Steckerverbindung zur Stromversorgung nötig ist. Durch diese Ausgestaltung wird der Verkabelungsaufwand der zu bestromenden Spulen erheblich betriebssicherer und erheblich einfacher im Aufbau.

Gemäß Anspruch 6 kann der Bestückkopf ferner eine zweite ferromagnetische Rückschlussplatte aufweisen, welche derart angeordnet ist, dass die Mobilteile mehrerer Linearmotoren in einem zwischen der ersten ferromagnetischen Rückschlussplatte und der zweiten ferromagnetischen Rückschlussplatte gebildeten Zwischenraum verfahrbar sind. Die zweite Rückschlussplatte ist als für mehrere Linearmotoren gemeinsame Rückschlussplatte ausgebildet, so dass auch hier wieder Einzelbauteile der Linearmotoren zu einem Bauteil zusammengefasst werden.

Gemäß Anspruch 7 kann die zweite Rückschlussplatte derart ausgestaltet werden, dass die auf die Mobilteile der Linearmotoren wirkende resultierende Magnetkraft senkrecht zu einer Verschieberichtung der Greifereinheiten reduziert ist. Ohne die zweite Rückschlussplatte wäre die Belastung der Linearführungen auf der zwischen dem Permanentmagneten 20 und dem Spulenelementen senkrecht zur Bewegungsrichtung wirkenden Magnetkraft erheblich. Durch die Anordnung einer zweiten Rückschlussplatte gemäß Anspruch 7 kann die Lagerbelastung jedoch erheblich reduziert werden.

Im Folgenden wird ein Ausführungsbeispiel des erfindungsgemäßen Bestückkopfes mit Bezug auf die beigefügten Zeichnungen näher erläutert. In den Figuren sind:
Figur 1 eine schematische Darstellung eines Teiles eines Bestückautomaten,
Figur 2 eine perspektivische Darstellung eines Ausführungsbeispiels des erfindungsgemäßen Bestückkopfes,
Figur 3 eine perspektivische Teilansicht des Bestückkopfes,
Figur 4 eine Frontalansicht des Bestückkopfes, und
Figur 5 eine Draufsicht des Bestückkopfes.

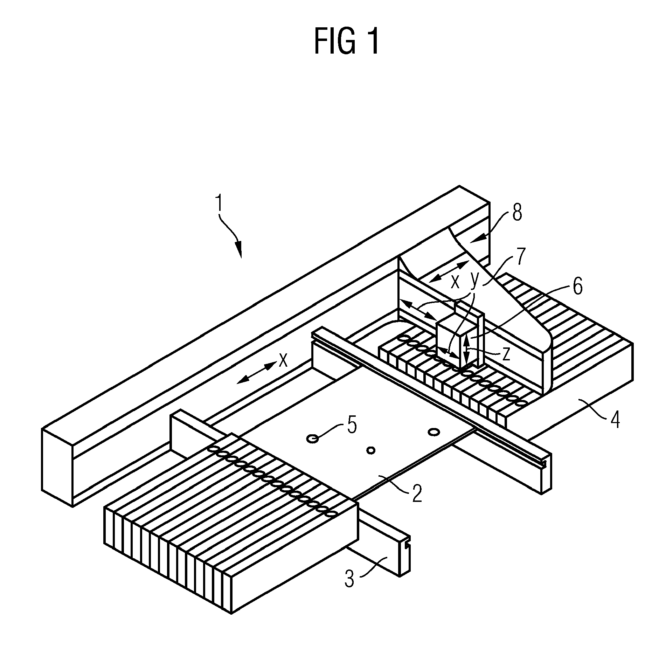

In Figur 1 ist eine Teilansicht eines Bestückautomaten 1 schematisch dargestellt. Zu bestückende Substrate 2 werden über eine Transportstrecke 3 zu einem Bestückbereich des Bestückautomaten 1 transportiert. Seitlich der Transportstrecke 3 sind in einem Zuführbereich Zuführeinrichtungen 4 angeordnet. Die Zuführeinrichtungen 4 dienen der Bereitstellung elektrischer Bauteile 5, welche auf dem Substrat 2 zu platzieren sind. Ein Bestückkopf 6 ist mittels eines zweidimensionalen Positioniersystems parallel zu einer Bestückebene verfahrbar. Das Positioniersystem umfasst einen freiragenden Trägerarm 7, welcher mittels eines geeigneten Antriebs entlang einer Führungseinrichtung 8 (Pfeil x) verschiebbar ist. An dem Trägerarm 7 ist der Bestückkopf 6 mit einem weiteren Antrieb in einer Richtung (Pfeil y) senkrecht zur Führungseinrichtung 8 verfahrbar angeordnet. Während eines Bestückvorgangs wird der Bestückkopf 6 zunächst in den Zuführbereich gefahren, um dort Bauteile 5 aufzunehmen, woraufhin er in den Bestückbereich zurückfährt, um die Bauteile 5 auf dem Substrat 2 abzusetzen.

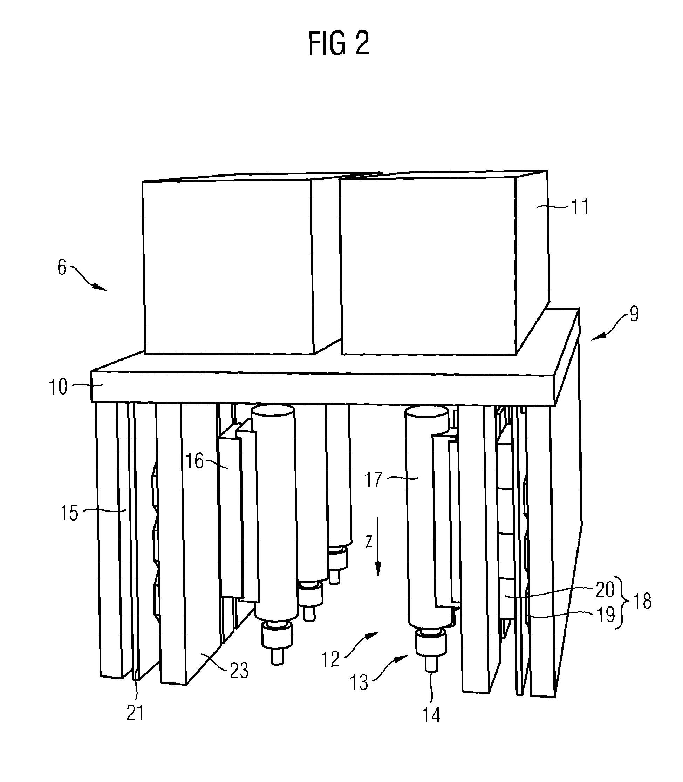

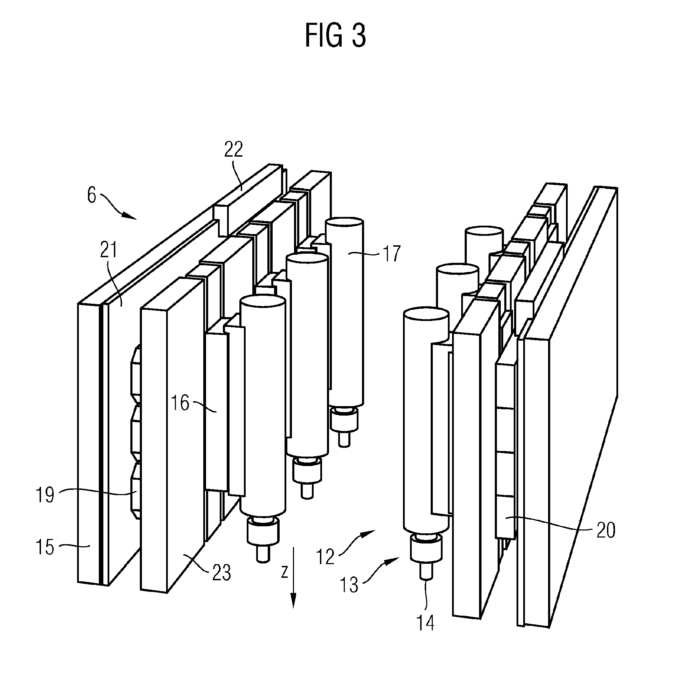

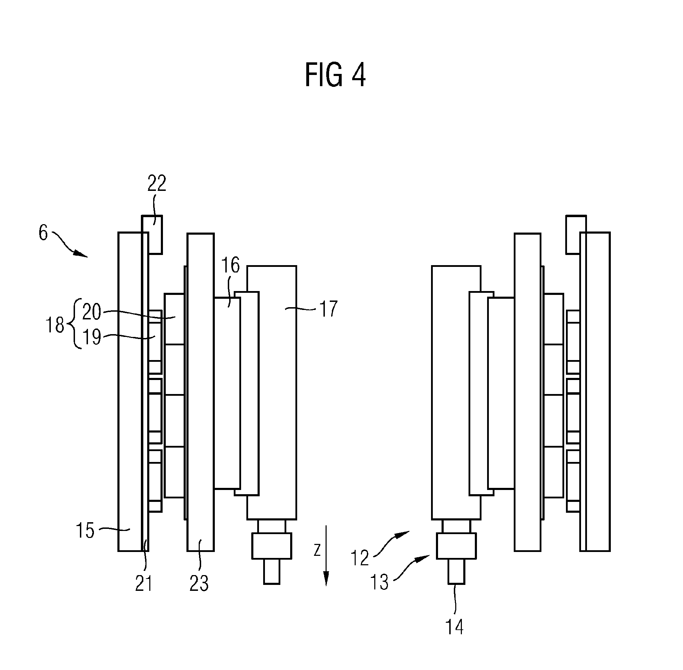

In den Figuren 2 bis 5 ist ein Ausführungsbeispiel des erfindungsgemäßen Bestückkopfes dargestellt, wie er in dem oben beschriebenen Bestückautomaten 1 eingesetzt werden kann. Der Bestückkopf 6 weist ein kastenförmiges Gehäuse 9 auf. Zur besseren Veranschaulichung des inneren Aufbaus ist der Bestückkopf 6 in Figur 2 jedoch ohne Frontabdeckung und in den Figuren 3 bis 5 zusätzlich ohne obere Abdeckplatte 10 und Aufbauten 11 dargestellt.

Im Ausführungsbeispiel handelt es sich um einen so genannten Matrix-Bestückkopf 6 mit sechs Greifereinheiten 12, welche in zwei Reihen zu je drei Greifereinheiten 12 angeordnet sind. Die beiden Reihen zu je drei Greifereinheiten 12 sind spiegelsymmetrisch angeordnet und weisen einen identischen Aufbau auf. Die folgende Beschreibung beschränkt sich teilweise auf eine Reihe von Greifereinheiten 12, gilt jedoch analog auch für die andere Reihe.

Die Greifereinheiten 12 können beispielsweise Sauggreifer 13 aufweisen, deren Spitze 14 durch Vakuum-Erzeugermodule 11, welche in Figur 2 schematisch als Aufbauten 11 auf der oberen Abdeckplatte 10 des Bestückkopfes 6 dargestellt sind, wahlweise mit Vakuum oder mit Druckluft beaufschlagt werden können.

Wie aus den Figuren 2 bis 5 weiter deutlich wird, weist der Bestückkopf 6 erfindungsgemäß eine Montagefläche 15 auf, welche beispielsweise durch eine Seitenwand 15 des Gehäuses 9 des Bestückkopfes gebildet werden kann. Die Greifereinheiten 12 sind an Linearführungen 16 angekoppelt und entlang dieser in einer Verschieberichtung (Pfeil Z) senkrecht zur Bestückebene des Bestückautomaten 1 (siehe Figur 1) verschiebbar, um Bauteile 5 aufzunehmen und auf dem Substrat 2 abzusetzen. In einem Greifergehäuse 17 kann ein bekanntermaßen ausgebildeter Drehantrieb vorgesehen sein, welcher die als Hohlwelle ausgebildete Greiferspitze drehbar antreibt, um aufgenommene Bauteile 5 in eine gewünschte Winkelposition zu bringen.

Der Bestückkopf 6 weist ferner mehrere Linearmotoren 18 auf, wobei jeder Greifereinheit 12 jeweils ein Linearmotor 18 zugeordnet ist, um diese entlang der Linearführung 16 relativ zu der Montagefläche 15 zu bewegen. Die Linearmotoren 18 umfassen, unter anderem, Stationärteile 19, welche an der Montageplatte befestigt sind, und Mobilteile 20, welche mit den Greifereinheiten 12 verbunden sind und dadurch ebenfalls relativ zu der Montagefläche 15 beweglich gelagert sind. Die Stationärteile 19 bestehen im Wesentlichen aus bestrombaren Spulenelementen, wogegen es sich bei den Mobilteilen um Permanentmagnete 20 handelt. Es ist jedoch auch eine Ausführung denkbar, bei der die Spulenelemente 19 die Mobilteile 20 und die Permanentmagnete 20 die Stationärteile 19 der Linearmotoren 18 darstellen. Jedoch bringt die im Ausführungsbeispiel dargestellte Ausgestaltung den Vorteil mit sich, dass die Stromversorgung der an die Montagefläche 15 befestigten Spulenelemente 19 erheblich einfacher zu gestalten ist, als in dem Fall, dass die Spulenelemente 19 als bewegbare Mobilteile 20 ausgebildet sind. In diesem Fall wären die Anforderungen an die Steckerverbindung und die Gefahr eines Defekts erheblich größer.

Bei dem erfindungsgemäßen Bestückkopf 6 sind die Stationärteile 19 mehrerer Linearmotoren 18 mit der Montagefläche 15 fest verbunden. Genauer gesagt sind die Spulenelemente 19 der Linearmotoren 18 einer Reihe an der jeweiligen Seitenwand 15 des Gehäuses 9, welche die Montagefläche bildet, befestigt. Die Seitenwand 15 bildet dadurch eine gemeinsame Montagefläche für die Spulenelemente bzw. Stationärteile mehrerer Linearmotoren. Die Seitenwand 15 des Gehäuses 9 des Bestückkopfs 6 kann ein Material mit hoher magnetischer Flussleitfähigkeit aufweisen, wodurch die Seitenwand 15 gleichzeitig die Funktion einer ersten gemeinsamen ferromagnetischen Rückschlussplatte 15 für die drei Linearmotoren 18 einer Reihe übernimmt. Durch den magnetischen Rückschluss wird der Wirkungsgrad der Linearmotoren 18 erheblich gesteigert. Die Stationärteile 19 bzw. die Spulenelemente 19 mehrerer Linearmotoren 18 sind daher auf der gemeinsamen Montagefläche 15 in Form einer ersten ferromagnetischen Rückschlussplatte 15 in einer Ebene nebeneinander angeordnet. Einander zugewandte Flächen der Mobilteile 20 (bzw. Permanentmagnete 20) und der Stationärteile 19 (bzw. Spulenelemente 19) eines jeden Linearmotors 18 sind dabei parallel zu der Montagefläche 15 angeordnet.

An der Montagefläche 15 ist zusätzlich eine Leiterplatte 21 mit integrierten Stromversorgungsleitungen (nicht dargestellt) befestigt, welche die Spulenelemente 19 mit einem gemeinsamen Stromanschluss 22 der Leiterplatte 21 verbinden. Dieser Aufbau gewährleistet eine sehr zuverlässige und einfache Stromversorgung der Spulenelemente 19 über den gemeinsamen Stromanschluss 22, was vor allem bei der Montage Vorteile mit sich bringt und die Kosten bei der Herstellung senkt.

Der Bestückkopf 6 verfügt ferner über eine zweite ferromagnetische Rückschlussplatte 23, welche derart angeordnet ist, dass die Permanentmagnete 20 mehrerer Linearmotoren 18 in einem zwischen der ersten ferromagnetischen Rückschlussplatte 15 und der zweiten ferromagnetischen Rückschlussplatte 23 gebildeten Zwischenraum verfahrbar sind. Die zweite ferromagnetische Rückschlussplatte 23 ist parallel zu der ersten ferromagnetischen Rückschlussplatte 15 angeordnet. Durch die zweite ferromagnetische Rückschlussplatte 23 kann die Effizienz der Linearmotoren 18 noch weiter gesteigert werden.

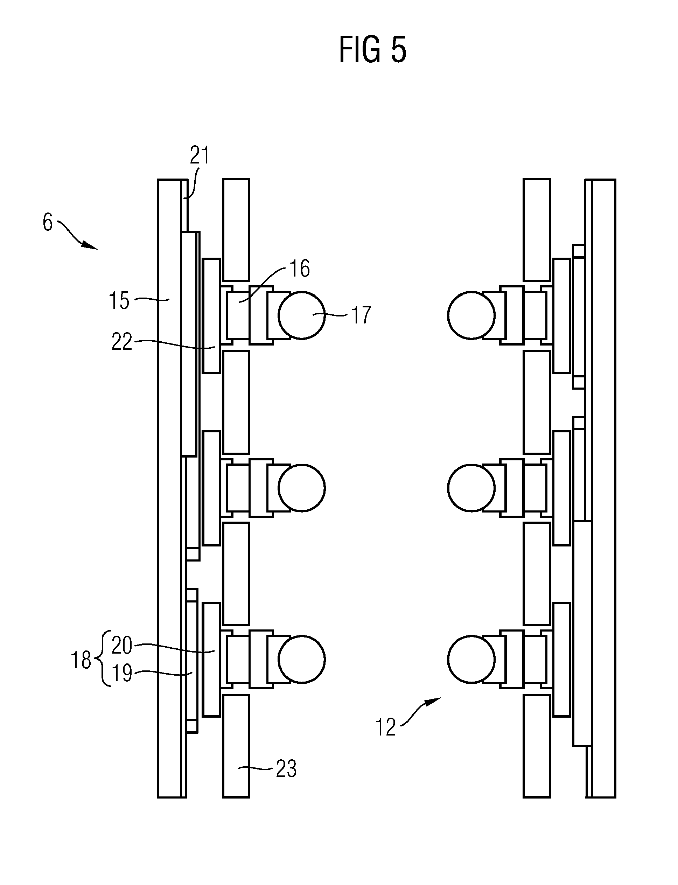

Wie aus Figur 5 hervorgeht, ist die zweite ferromagnetische Rückschlussplatte 23 derart ausgebildet, dass die in einer Richtung senkrecht zur Verschieberichtung (in Figuren 2-4 Pfeil z) gerichtete, auf die Permanentmagnete 20 (bzw. Mobilteile 20) der Linearmotoren 18 wirkende resultierende Magnetkraft reduziert ist. Die resultierende Magnetkraft ergibt sich aus der Summe der Magnetkraft, die zwischen den Permanentmagneten 20 und der ersten Rückschlussplatte 15 wirkt, und der entgegengesetzt gerichteten Magnetkraft, die zwischen den Permanentmagneten 20 und der zweiten Rückschlussplatte 23 wirkt. Die Magnetkräfte, die dabei auf die Permanentmagnete wirken, sind einerseits von dem Abstand zwischen den Permanentmagneten 20 und der ersten Rückschlussplatte 15 bzw. der zweiten Rückschlussplatte 23 und andererseits von der Größe der magnetischen Wirkfläche zwischen den Permanentmagneten 20 und der ersten bzw. der zweiten ferromagnetischen Rückschlussplatte 23 abhängig. Die magnetische Wirkfläche ergibt sich dabei aus der Überlappung der Flächen bei einer Projektion der Permanentmagnete 20 senkrecht auf die jeweilige ferromagnetische Rückschlussplatte 15 bzw. 23. Allgemein wachsen die zwischen den Permanentmagneten 20 und der ersten bzw. zweiten Rückschlussplatte 15 bzw. 23 wirkenden Magnetkräfte mit geringer werdendem Abstand und größer werdender magnetischer Wirkfläche an.

Aus Figur 5 wird deutlich, dass der Abstand zwischen den Permanentmagneten 20 und der ersten ferromagnetischen Rückschlussplatte 15 deutlich größer ist als der Abstand zwischen den Permanentmagneten 20 und der zweiten ferromagnetischen Rückschlussplatte 23. Andererseits ist die magnetische Wirkfläche zwischen den Permanentmagneten 20 und der ersten ferromagnetischen Rückschlussplatte 15 deutlich größer ist als die magnetische Wirkfläche zwischen den Permanentmagneten 20 und der zweiten ferromagnetischen Rückschlussplatte 23. Die zweite ferromagnetische Rückschlussplatte 23 daher so ausgebildet und so angeordnet, dass die durch den Abstand und die magnetische Wirkfläche zwischen den Permanentmagneten 20 und der zweiten ferromagnetischen Rückschlussplatte 23 bestimmte Magnetkraft die entgegengesetzt gerichtete Magnetkraft zwischen den Permanentmagneten 20 und der ersten ferromagnetischen Rückschlussplatte 15 weitgehend kompensiert. Dadurch wird die Lagerbelastung auf den Linearführungen 16 minimiert.

Wie aus der obigen Beschreibung hervorgeht, ist es durch die erfindungsgemäße Anordnung der Stationärteile 19 mehrerer Linearmotoren 18 auf einer gemeinsamen Montagefläche 15 möglich, Teile der Linearmotoren 18 möglichst weit zusammen zu fassen, was Kostenvorteile bei der Herstellung des Bestückkopfes mit sich bringt. Ferner können die Spulenelemente 19 mehrerer Motoren zusammen mit der gemeinsamen ersten ferromagnetischen Rückschlussplatte 15 und der gemeinsamen Leiterplatte 21 mit dem gemeinsamen Stromanschluss 22 als eine Montageeinheit aufgebaut und vormontiert werden. Dies hat nicht nur Kostenvorteile, sondern vereinfacht auch die Montage des Bestückkopfes erheblich. Durch die geschickte Ausgestaltung der zweiten ferromagnetischen Rückschlussplatte 23 kann die Effizienz der Linearmotoren 18 gesteigert werden, sowie die auf die Linearführung 16 wirkenden Lagerkräfte reduziert werden. Durch die Zusammenfassung von Einzelteilen der Linearmotoren 18 kann auch das Gewicht und die Größe des Bestückkopfes deutlich reduziert werden.

Ferner kann an der Leiterplatte 21 eine Längenmesseinrichtung (nicht dargestellt) angebracht werden, mittels der die Verschiebelänge der Linearmotoren 18 längs der Linearführung 16 relativ zur Montagefläche 15 erfasst werden können. In einer konkreten Ausgestaltung wäre dies dadurch realisierbar, dass an der Leiterplatte 21 für jeden Linearmotor 18 ein Längenmaßstab aufgeätzt ist, welcher mittels eines an der Greifereinheit 12 angebrachten Sensors abgetastet wird, wobei die dadurch erhaltenen Daten mittels einer Rechnereinheit im Bestückkopf 6 oder im Bestückautomat 1 eine exakte Position der Greifereinheiten 12 interpretiert werden können. Es wäre jedoch auch denkbar, den Längenmaßstab an dem Mobilteil des Linearmotors oder an der Greifereinheit 12 anzuordnen und den Sensor auf der Leiterplatte 21 anzubringen. In diesem Fall kann die Verdrahtung zur Stromversorgung des Sensors und zur Datenübertragung von dem Sensor zu einer Rechnereinheit an der Leiterplatte 21 vorgesehen werden.

### Bezugszeichenliste:

- 1: Bestückautomat
- 2: Substrat
- 3: Transportstrecke
- 4: Zuführeinrichtung
- 5: elektrische Bauteile
- 6: Bestückkopf
- 7: Trägerarm
- 8: Führungseinrichtung
- 9: Gehäuse
- 10: obere Abdeckplatte
- 11: Aufbauten mit Vakuum-Erzeugermodul
- 12: Greifereinheit
- 13: Sauggreifer
- 14: Greiferspitze
- 15: Montagefläche/Seitenwand/erste ferromagnetische Rückschlussplatte
- 16: Linearführung
- 17: Greifergehäuse
- 18: Linearmotor
- 19: Stationärteile/Spulenelemente
- 20: Mobilteile/Permanentmagnete
- 21: Leiterplatte
- 22: Stromanschluss
- 23: Zweite ferromagnetische Rückschlussplatte

## Patentansprüche

1. Bestückkopf (6) für einen Bestückautomat (1) zum Bestücken von Substraten mit elektrischen Bauteilen (5), mit
- einer Montagefläche (15),
- mehreren Linearführungen (16),
- mehreren Greifereinheiten (12), welche jeweils mit einer der Linearführungen (16) gekoppelt und entlang der jeweiligen Linearführung (16) relativ zur Montagefläche (15) verschiebbar sind, und
- mehreren Linearmotoren (18), welche jeweils einer der Greifereinheiten (12) zugeordnet und derart angeordnet sind, dass die Greifereinheiten (12) mittels der Linearmotoren (18) entlang der Linearführungen (16) verfahrbar sind, wobei Stationärteile (19) der Linearmotoren (18) mit der Montagefläche (15) und Mobilteile (20) der Linearmotoren (18) mit den Greifereinheiten (12) fest verbunden sind.

2. Bestückkopf (6) nach Anspruch 1, wobei die Stationärteile (19) der Linearmotoren (18) an der Montagefläche (15) in einer gemeinsamen Ebene derart angeordnet sind, dass einander zugewandte Flächen der Stationärteile (19) und der Mobilteile (20) parallel zu der Montagefläche (15) sind.

3. Bestückkopf (6) nach einem der Ansprüche 1 bis 2, wobei die Montagefläche (15) als eine erste gemeinsame ferromagnetische Rückschlussplatte (15) für die Linearmotoren (18) ausgebildet ist.

4. Bestückkopf (6) nach einem der Ansprüche 1 bis 2, wobei die Stationärteile (19) Spulenelemente (19) und die Mobilteile (20) Permanentmagnete (20) aufweisen.

5. Bestückkopf (6) nach Anspruch 4, wobei die Montagefläche (15) eine Leiterplatte (21) mit einem gemeinsamen Stromanschluss (22) aufweist, über welchen die Spulenelemente (19) mit einer Stromversorgung verbindbar sind.

6. Bestückkopf (6) nach einem der Ansprüche 3 bis 5, mit einer zweiten ferromagnetischen Rückschlussplatte (23), welche derart angeordnet ist, dass die Mobilteile (20) der Linearmotoren (18) in einem zwischen der ersten ferromagnetischen Rückschlussplatte (15) und der zweiten ferromagnetischen Rückschlussplatte (23) gebildeten Zwischenraum verfahrbar sind.

7. Bestückkopf (6) nach Anspruch 6, wobei die zweite Rückschlussplatte (23) derart ausgestaltet ist, dass die auf die Mobilteile (20) der Linearmotoren (18) wirkende resultierende Magnetkraft senkrecht zu einer Verschieberichtung der Greifereinheiten (12) reduziert ist.
